# EUROPÄISCHE PATENTSCHRIFT

(11) **EP 3 955 717 B1**
(45) Veröffentlichungstag und Bekanntmachung des Hinweises auf die Patenterteilung: **25.12.2024**
(21) Anmeldenummer: 20191124.5
(22) Anmeldetag: 14.08.2020
(51) Int. Cl.: H05K 7/20, H05K 7/14

(54) **MULTILEVEL-STROMRICHTER MIT OPTIMIERTER TOPOLOGIE**
MULTI-LEVEL POWER CONVERTER WITH OPTIMIZED TOPOLOGY
CONVERTISSEUR MULTI-NIVEAU À TOPOLOGIE OPTIMISÉE

(43) Veröffentlichungstag der Anmeldung: 16.02.2022
(73) Patentinhaber: Siemens Aktiengesellschaft, 80333 München (DE)
(72) Erfinder: Namyslo, Lutz, 91353 Hausen (DE); Schmenger, Jens, 91301 Forchheim (DE)
(74) Vertreter: Siemens Patent Attorneys

(56) Entgegenhaltungen:
- EP-A1- 3 157 154
- DE-A1- 102015 224 431
- US-A1- 2019 267 912
- US-A1- 2020 204 082

## Beschreibung

Die vorliegende Erfindung geht aus von einer elektronischen Leistungsschaltung,
- wobei die elektronische Leistungsschaltung ein Substrat mit einer Oberseite und einer Unterseite aufweist,
- wobei die Unterseite des Substrats mit einem Kühlkörper verbunden ist,
- wobei auf der Oberseite des Substrats erste elektronische Schaltelemente angeordnet sind, mittels derer ein an einem Phasenanschluss der Leistungsschaltung anstehendes Wechselspannungspotenzial auf ein an einem ersten Potenzialanschluss der Leistungsschaltung anstehendes hohes Gleichspannungspotenzial und auf ein an einem zweiten Potenzialanschluss der Leistungsschaltung anstehendes niedriges Gleichspannungspotenzial durchgeschaltet werden kann,
- wobei die elektronische Leistungsschaltung zweite elektronische Schaltelemente aufweist, mittels derer das an dem Phasenanschluss anstehende Wechselspannungspotenzial auf ein an einem dritten Potenzialanschluss der Leistungsschaltung anstehendes mittleres Gleichspannungspotenzial durchgeschaltet werden kann,
- wobei die elektronische Leistungsschaltung zusätzlich zu dem Substrat eine erste Leiterplatte mit einer Oberseite und einer Unterseite aufweist,
- wobei das Substrat in einem Abstand von der ersten Leiterplatte unter der Unterseite der ersten Leiterplatte angeordnet ist, so dass die Oberseite des Substrats der ersten Leiterplatte zugewandt ist,
- wobei das Substrat mit der ersten Leiterplatte elektrisch verbunden ist.

Derartige elektronische Leistungsschaltungen sind allgemein bekannt. Insbesondere sogenannte 3L-Stromrichter (3L = 3 Level = 3 verschiedene Spannungsniveaus auf Gleichspannungsseite) sind derart ausgebildet. Das mittlere Gleichspannungspotenzial liegt, wie schon sein Name sagt, zwischen dem hohen und dem niedrigen Gleichspannungspotenzial. Meist liegt es in der Mitte oder zumindest in etwa in der Mitte zwischen dem hohen und dem niedrigen Gleichspannungspotenzial.

Aus der WO 2020/052 829 A1 ist eine Leistungsmoduleinheit bekannt, die ein Substrat mit einer Oberseite und einer Unterseite aufweist. Auf der Oberseite des Substrats sind Leistungshalbleiter angeordnet. Die Unterseite des Substrats ist mit einem Kühlkörper verbunden.

Die Offenlegungsschrift DE 10 2015 224 431 A1 beschreibt ein Halbleiterbauelement, das Folgendes beinhaltet: mehrere Halbleitereinheiten, die jeweils eine Dreipunkt-Wechselrichter-Schaltung bilden und eine Verbindungseinheit, die die mehreren Halbleitereinheiten elektrisch parallel schaltet, wobei jede der Halbleitereinheiten Folgendes beinhaltet: ein mehrschichtiges Substrat, das eine Isolierplatte und Schaltungsplatten, die auf einer primären Fläche der Isolierplatte angeordnet sind, beinhaltet, mehrere Halbleiterelemente, die jeweils eine Rückfläche davon, die an einer der Schaltungsplatten befestigt ist, und eine Vorderfläche davon mit Primärelektroden aufweisen und Verdrahtungselemente, die elektrisch mit den Primärelektroden der Halbleiterelemente verbunden sind, und wobei in jeder der Halbleitereinheiten das mehrschichtige Substrat, die mehreren Halbleiterelemente und die Verdrahtungselemente derart konfiguriert sind, dass sie die Dreipunkt-Wechselrichter-Schaltung bilden.

Die Offenlegungsschrift US 2020/0204082 A1 beschreibt eine Leistungsumwandlungsvorrichtung, die erste bis vierte Schaltelemente und erste bis achte Dioden enthält. Die erste bis vierte Diode sind elektrisch invers parallel zu dem ersten bis vierten Schaltelement geschaltet. Die siebte Diode ist elektrisch parallel zu der zweiten Diode geschaltet. Die achte Diode ist elektrisch parallel zur dritten Diode geschaltet. Die zweite Diode ist in einem ersten Gehäuse untergebracht. Die siebte Diode ist in einem zweiten Gehäuse untergebracht, das sich vom ersten Gehäuse unterscheidet und die Schaltelemente nicht enthält. Die achte Diode ist in dem zweiten Gehäuse untergebracht, oder alternativ ist die achte Diode in einem anderen Gehäuse untergebracht, das sich von dem ersten Gehäuse und dem zweiten Gehäuse unterscheidet und das die Schaltelemente nicht enthält.

In jüngerer Zeit sind vermehrt elektronische Halbleiterschalter bekannt geworden, die als sogenannte WBG-Bauelemente bezeichnet werden. Die Abkürzung "WBG" steht in diesem Zusammenhang für "wide band gap". Typische Vertreter derartiger Halbleiterschalter sind Schaltelemente auf Basis von Siliziumcarbid (SiC) und Galliumnitrid (GaN). Auch neuere Schaltelemente auf Basis von Silizium (Si) sind hier zu nennen. Die Schaltelemente können beispielsweise Thyristoren, IGBTs und FETs (einschließlich MOSFETs und JFETs) sein.

Schaltelemente auf Basis von Galliumnitrid weisen eine Vielzahl von technologischen Vorteilen auf. Insbesondere weisen sie eine extrem kurze Schaltzeit auf, d.h. sie können in einer sehr kurzen Zeit vom gesperrten (= nicht stromleitenden) in den durchgeschalteten (= stromleitenden) Zustand bzw. umgekehrt vom durchgeschalteten in den gesperrten Zustand überführt werden. Die Schaltzeiten können im Bereich von wenigen ns und sogar unter 1 ns liegen. Schaltelemente auf Basis von Galliumnitrid weisen in der praktischen Anwendung jedoch auch einige Nachteile auf. So verkraften derartige Schaltelemente beispielsweise einen Kurzschluss nur für eine erheblich kürzere Zeitdauer als andere Schaltelemente. Weiterhin sind sie in der Regel nur in einem Gehäuse verfügbar, nicht aber als gehäuselose Schaltelemente (bare die). Dadurch können die in den entsprechenden Schaltelementen auf Galliumnitrid-Basis anfallenden Verluste nur relativ schlecht abgeführt werden. Schließlich sind bauartbedingte maximale geschaltete Spannungen bei Schaltelementen auf Galliumnitrid-Basis auf einen Bereich von deutlich unter 1 kV beschränkt. In der Praxis liegt die Grenze zur Zeit bei ca. 650 V.

Im Vergleich zu Schaltelementen auf Basis von Galliumnitrid verkraften Schaltelemente auf Basis von Siliziumcarbid einen Kurzschluss für eine deutlich längere Zeitdauer. Sie sind sowohl in einem Gehäuse als auch als gehäuselose Schaltelemente (bare die) verfügbar. Es sind Bauformen am Markt verfügbar, bei denen die bauartbedingte maximale geschaltete Spannung in einem Bereich von mehreren kV liegt, beispielsweise bei bis zu 3 kV.

In der Praxis werden daher bei Stromrichtern, Schaltnetzteilen und dergleichen, bei denen hohe Spannungen und große Leistungen geschaltet werden, trotz der Vorteile von Schaltelementen auf Basis von Galliumnitrid Schaltelemente auf Basis von Siliziumcarbid verwendet, da diese ohne größere Probleme auf einem Substrat angeordnet werden können und dort gut gekühlt werden können. Bei geringeren Spannungen und/oder geringeren Leistungen werden im Stand der Technik teilweise auch Schaltelemente auf Basis von Galliumnitrid verwendet. Diese Schaltelemente werden in diesem Fall jedoch auf einer üblichen, konventionell ausgebildeten Leiterplatte angeordnet.

Die Aufgabe der vorliegenden Erfindung besteht darin, eine elektronische Leistungsschaltung der eingangs genannten Art dahingehend weiterzuentwickeln, dass sie auf einfache, kostengünstige und technisch vorteilhafte Art und Weise ausgebildet ist.

Die Aufgabe wird durch eine elektronische Leistungsschaltung mit den Merkmalen des Anspruchs 1 gelöst. Vorteilhafte Ausgestaltungen der elektronischen Leistungsschaltung sind Gegenstand der abhängigen Ansprüche 2 bis 13.

Erfindungsgemäß wird eine elektronische Leistungsschaltung der eingangs genannten Art dadurch ausgestaltet,
- dass die zweiten elektronischen Schaltelemente zumindest auf der Oberseite der ersten Leiterplatte, gegebenenfalls zusätzlich auch auf der Unterseite der ersten Leiterplatte, angeordnet sind.

Aufgrund der Anordnung der ersten elektronischen Schaltelemente auf dem Substrat können - wie im Stand der Technik auch - hohe Spannungen und große Leistungen geschaltet werden, wobei dennoch über den Kühlkörper eine gute Abfuhr der in den ersten elektronischen Schaltelementen anfallenden Verlustleistung möglich ist. Durch die Anordnung der zweiten elektronischen Schaltelemente auf der ersten Leiterplatte können einfache Realisierungen der Schaltung erfolgen. Insbesondere müssen die zweiten elektronischen Schaltelemente nicht auf dem Substrat angeordnet sein, so dass die über den Kühlkörper abzuführende Verlustleistung kleiner ist, als wenn - wie im Stand der Technik üblich - zusätzlich zu den ersten elektronischen Schaltelemente auch die zweiten elektronischen Schaltelemente auf dem Substrat angeordnet wären. Weiterhin steht mehr Platz - nämlich die Fläche des Substrats zuzüglich der Fläche der Leiterplatte - für die Platzierung der ersten und zweiten elektronischen Schaltelemente zur Verfügung.

Vorzugsweise weisen die ersten elektronischen Schaltelemente im Betrieb der elektronischen Leistungsschaltung eine höhere Verlustleistung auf als die zweiten elektronischen Schaltelemente. Dadurch ruft die Anordnung der zweiten elektronischen Schaltelemente keine größeren Probleme bei der Abfuhr der im Betrieb anfallenden Verlustleistung der zweiten elektronischen Schaltelemente hervor.

Das Wechselspannungspotenzial variiert als Funktion der Zeit zwischen einem oberen und einem unteren Wert. Meist liegen der obere und der untere Wert im Bereich des hohen und des niedrigen Gleichspannungspotenzials. Es ist möglich, dass die geringere Verlustleistung der zweiten elektronischen Schaltelemente sich ganz von selbst aufgrund der im Mittel geringeren geschalteten Potenzialdifferenz ergibt. Es sind aber auch andere Gründe möglich. Insbesondere ist es möglich, dass die Ursache für die voneinander verschiedenen Verlustleistungen darin besteht, dass die ersten elektronischen Schaltelemente eine höhere Durchlassspannung und/oder größere Schaltzeiten und/oder einen größeren Leitendwiderstand als die zweiten elektronischen Schaltelemente aufweisen.

Die Durchlassspannung ist die Spannung, die im durchgeschalteten Zustand des jeweiligen elektronischen Schaltelements über dem jeweiligen elektronischen Schaltelement abfällt. Sie ergibt in Verbindung mit dem geschalteten Strom die im jeweiligen elektronischen Schaltelement anfallende Verlustleistung (Leistung = Spannung x Strom). Die Schaltzeit ist diejenige Zeit, die zum Umschalten des jeweiligen elektronischen Schaltelements vom gesperrten in den durchgeschalteten Zustand oder zurück benötigt wird. Während des Umschaltens befindet sich das jeweilige elektronische Schaltelement in einem transienten Zustand, in dem einerseits über dem jeweiligen elektronischen Schaltelement eine relativ hohe Spannung (deutlich oberhalb der Durchlassspannung) abfällt und andererseits bereits ein nennenswerter Strom fließt. Der transiente Zustand darf nur kurzzeitig beibehalten werden. Je länger der transiente Zustand dauert, je größer also die Schaltzeit ist, desto größer ist die Schaltenergie, die im jeweiligen elektronischen Schaltelement bei einem einzelnen Umschaltvorgang anfällt und als Wärme abgeführt werden muss.

Ursache für voneinander verschiedene Durchlassspannungen und/oder voneinander verschiedene Schaltzeiten kann insbesondere sein, dass die ersten elektronischen Schaltelemente und die zweiten elektronischen Schaltelemente in unterschiedlichen Halbleitertechnologien realisiert sind. Insbesondere können die ersten elektronischen Schaltelemente als Schaltelemente auf Siliziumcarbid-Basis ausgebildet sein und können die zweiten elektronischen Schaltelemente als Schaltelemente auf Galliumnitrid-Basis ausgebildet sein.

Vorzugsweise sind die ersten elektronischen Schaltelemente als gehäuselose Schaltelemente ausgebildet. Derartige Schaltelemente werden in Fachkreisen als bare die-Elemente bezeichnet. Aufgrund der Verwendung gehäuseloser Schaltelemente kann die in den ersten elektronischen Schaltelementen anfallende Verlustleistung besonders schnell auf das Substrat und von dort weiter auf den Kühlkörper übertragen werden.

Die zweiten elektronischen Schaltelemente sind hingegen vorzugsweise als in einem Gehäuse angeordnete Schaltelemente ausgebildet, wobei die zweiten elektronischen Schaltelemente weiterhin mit dem Gehäuse auf der ersten Leiterplatte befestigt sind. Dadurch können insbesondere im Falle der Verwendung von Schaltelementen auf Galliumnitrid-Basis zweite elektronische Schaltelemente verwendet werden, wie sie handelsüblich verfügbar sind. In der Regel sind die zweiten elektronischen Schaltelemente auf die erste Leiterplatte aufgelötet. Sie können aber auch durch Klemmung auf der ersten Leiterplatte befestigt sein.

Jedes elektronische Schaltelement weist bauartbedingt eine maximale geschaltete Spannung auf. Die maximale geschaltete Spannung ist diejenige Spannung, die das jeweilige elektronische Schaltelement noch zuverlässig sperren und auch gesperrt halten kann. Bei Spannungen oberhalb der maximalen geschalteten Spannung hingegen besteht die Gefahr, dass kein Umschalten vom durchgeschalteten in den gesperrten Zustand mehr möglich ist und/oder dass ein elektrischer Durchschlag mit einem unmittelbar darauf folgenden Durchlegieren des elektronischen Schaltelements erfolgt, so dass das elektronische Schaltelement permanent leitend wird. Vorzugsweise sind die bauartbedingten maximalen geschalteten Spannungen der ersten elektronischen Schaltelemente größer als die bauartbedingten maximalen geschalteten Spannungen der zweiten elektronischen Schaltelemente. In der Regel liegt der Quotient dieser Spannungen zwischen 1,2 und 2,0. Die bauartbedingten maximalen geschalteten Spannungen der ersten elektronischen Schaltelemente sind also in der Regel um 20 % bis 100 % größer als die bauartbedingten maximalen geschalteten Spannungen der zweiten elektronischen Schaltelemente. Besonders bevorzugt liegen die bauartbedingten maximalen geschalteten Spannungen der ersten elektronischen Schaltelemente oberhalb der Spannung die für Schaltelemente auf Basis von Galliumnitrid möglich ist, während die bauartbedingten maximalen geschalteten Spannungen der zweiten elektronischen Schaltelemente unterhalb dieser Spannung liegen.

Durch das Durchschalten der ersten elektronischen Schaltelemente werden erste Strompfade elektrisch leitend miteinander verbunden. Durch das Sperren der ersten elektronischen Schaltelemente werden die ersten Strompfade elektrisch voneinander getrennt. Die ersten Strompfade werden also mittels der ersten elektronischen Schaltelemente geschaltet. Vorzugsweise sind die ersten elektronischen Schaltelemente mittels erste Kondensatoren enthaltender erster Hilfsschaltungen überbrückt. Dadurch ergibt sich ein verbesserter Stromverlauf. Die ersten Hilfsschaltungen sind vorzugsweise auf dem Substrat angeordnet. Dadurch können die ersten Hilfsschaltungen besonders effektiv wirken.

In analoger Weise werden durch das Durchschalten und das Sperren der zweiten elektronischen Schaltelemente zweite Strompfade elektrisch leitend miteinander verbunden und elektrisch voneinander getrennt, also geschaltet. Vorzugsweise sind die zweiten elektronischen Schaltelemente mittels zweite Kondensatoren enthaltender zweiter Hilfsschaltungen überbrückt. Dadurch ergibt sich - wie zuvor - ein verbesserter Stromverlauf. Die zweiten Hilfsschaltungen sind vorzugsweise auf der ersten Leiterplatte angeordnet. Dadurch können die zweiten Hilfsschaltungen besonders effektiv wirken.

Die ersten und zweiten Kondensatoren der Hilfsschaltungen sind in Fachkreisen als Impulskondensatoren bekannt. Sie sind in der Regel als Keramikkondensatoren ausgebildet.

Vorzugsweise sind auf der Unterseite der ersten Leiterplatte Kühlelemente angeordnet, mittels derer in den zweiten elektronischen Schaltelementen anfallende Verlustleistungen abgeführt werden. Dadurch ist es unkritisch, wenn in den zweiten elektronischen Schaltelementen relativ große Verlustleistungen anfallen.

Die Kühlelemente erstrecken sich nur so weit von der ersten Leiterplatte weg, dass sie von dem Substrat noch beabstandet sind. Sie können auch als Kühlkörper angesehen werden. Die Wortwahl "Kühlelemente" (im Gegensatz zu "Kühlkörper") dient im Wesentlichen der sprachlichen Unterscheidung zum Kühlkörper des Substrats.

Vorzugsweise ist zwischen der ersten Leiterplatte und dem Substrat mindestens eine mit der ersten Leiterplatte und/oder dem Substrat elektrisch verbundene zweite Leiterplatte angeordnet. Dadurch ergeben sich eine größere Flexibilität bei der Anordnung von verschiedenen elektronischen Bauelementen (Schaltelementen und anderen) und eine verbesserte Ausnutzung des von der elektronischen Leistungsschaltung benötigten Volumens.

Vorzugsweise ist die Unterseite des Substrats mit dem Kühlkörper direkt, über eine Wärmeleitpaste oder über eine Metallschicht verbunden. Dadurch kann die in den ersten elektronischen Schaltelementen anfallende Verluste besonders gut auf den Kühlkörper abgeführt werden.

Oftmals wird die erfindungsgemäße elektronische Leistungsschaltung bei einem Stromrichter verwendet. Ein Stromrichter kann beispielsweise ein Gleichrichter, ein Wechselrichter, ein Umrichter oder ein Gleichspannungswandler sein. Alternativ kann die erfindungsgemäße elektronische Leistungsschaltung bei einem Schaltnetzteil verwendet werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: ein elektrisches Blockschaltbild einer elektronischen Leistungsschaltung,
- FIG 2: ein Zeitdiagramm,
- FIG 3: einen mechanisch-konstruktiven Aufbau der elektronischen Leistungsschaltung von FIG 1,
- FIG 4: ein Substrat und einen Kühlkörper,
- FIG 5: ein Substrat und einen Kühlkörper,
- FIG 6: ein Zeitdiagramm und
- FIG 7: Strom-Spannung-Kennlinien,
- FIG 8: eine Modifikation des elektrischen Blockschaltbildes von FIG 1 und
- FIG 9: eine Modifikation des mechanisch-konstruktiven Aufbaus von FIG 3.

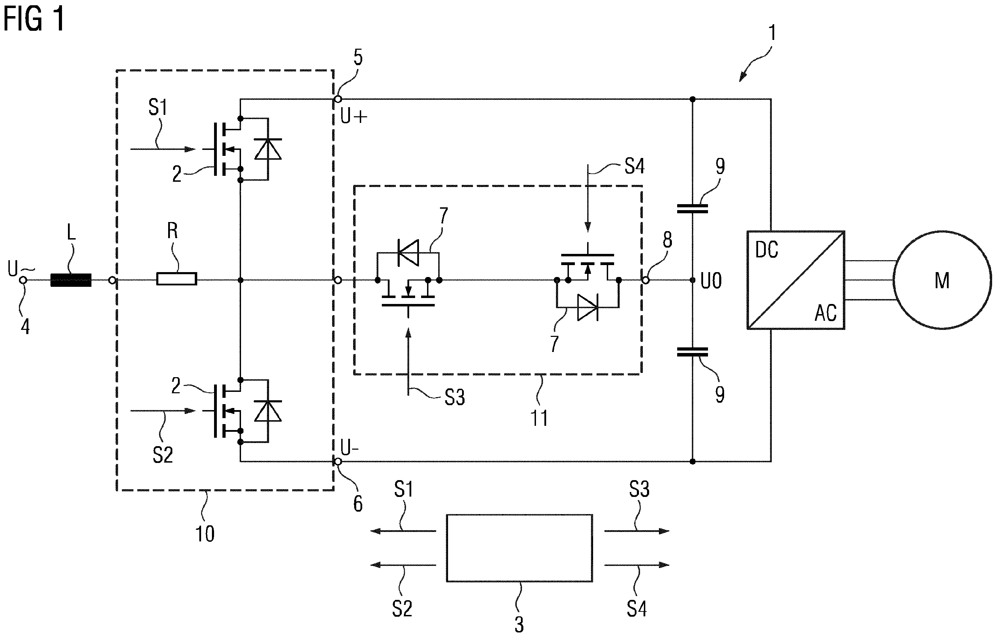

Gemäß FIG 1 zeigt eine elektronische Leistungsschaltung 1 und eine nachgeordnete Last in Form eines Wechselrichters und eines Motors. Die nachgeordnete Last ist nicht Gegenstand der vorliegenden Erfindung.

Die elektronische Leistungsschaltung 1 weist erste elektronische Schaltelemente 2 auf. Die ersten elektronischen Schaltelemente 2 können beispielsweise als Thyristoren, als IGBTs (= insulated gate bipolar transistor) oder entsprechend der Darstellung in FIG 1 als FETs (= Feldeffekttransistoren) ausgebildet sein. Ein Spezialfall von FETs sind MOSFETs. Den ersten elektronischen Schaltelementen 2 sind entsprechend der Darstellung in FIG 1 in der Regel Dioden parallel geschaltet. Die Dioden können eigenständige Bauelemente oder intrinsische Bestandteile der ersten elektronischen Schaltelemente 2 sein.

Die ersten elektronischen Schaltelemente 2 können alternativ durchgeschaltet oder gesperrt sein. Der jeweilige Schaltzustand wird durch Steuersignale S1, S2 bestimmt, die den ersten elektronischen Schaltelementen 2 zugeführt werden. Die Steuersignale S1, S2 werden von einer Steuereinrichtung 3 generiert.

Mittels eines der beiden ersten elektronischen Schaltelemente 2 kann ein Wechselspannungspotenzial U~ auf ein hohes Gleichspannungspotenzial U+ durchgeschaltet werden. Mittels des anderen der beiden ersten elektronischen Schaltelemente 2 kann das Wechselspannungspotenzial U~ auf ein niedriges Gleichspannungspotenzial U- durchgeschaltet werden. Das Wechselspannungspotenzial U~ steht an einem Phasenanschluss 4 der Leistungsschaltung 1 an, das hohe Gleichspannungspotenzial U+ an einem ersten Potenzialanschluss 5 der Leistungsschaltung 1, das niedrige Gleichspannungspotenzial U- an einem zweiten Potenzialanschluss 6 der Leistungsschaltung 1.

Die elektronische Leistungsschaltung 1 weist weiterhin zweite elektronische Schaltelemente 7 auf. In der Regel sind zwei zweite Schaltelemente 7 vorhanden, die entsprechend der Darstellung in FIG 1 seriell hintereinander geschaltet sind. Die zweiten elektronischen Schaltelemente 7 können analog zu den ersten elektronischen Schaltelementen 2 beispielsweise als Thyristoren, als IGBTs oder als FETs ausgebildet sein. Den ersten elektronischen Schaltelementen 7 sind entsprechend der Darstellung in FIG 1 in der Regel ebenfalls Dioden parallel geschaltet. Die Dioden können wie analog zu den den ersten elektronischen Schaltelementen 2 parallel geschalteten Dioden eigenständige Bauelemente oder intrinsische Bestandteile der zweiten elektronischen Schaltelemente 7 sein.

Die beiden zweiten elektronischen Schaltelemente 7 können alternativ durchgeschaltet oder gesperrt sein. Der jeweilige Schaltzustand wird durch Steuersignale S3, S4 bestimmt, die den zweiten elektronischen Schaltelementen 7 zugeführt werden. Die Steuersignale S3, S4 werden ebenfalls von der Steuereinrichtung 3 generiert. In vielen Fällen kann eine gleichartige Ansteuerung der beiden zweiten elektronischen Schaltelemente 7 erfolgen, dass die zweiten elektronischen Schaltelemente 7 also entweder beide durchgeschaltet oder beide gesperrt sind.

Mittels der zweiten elektronischen Schaltelemente 7 kann das Wechselspannungspotenzial U~ auf ein mittleres Gleichspannungspotenzial U0 durchgeschaltet werden. Das mittlere Gleichspannungspotenzial U0 steht an einem dritten Potenzialanschluss 8 der elektronischen Leistungsschaltung 1 an. Es liegt zwischen dem hohen und dem niedrigen Gleichspannungspotenzial U+, U-, meist (zumindest in etwa) in der Mitte zwischen den beiden anderen Gleichspannungspotenzialen U+, U-.

In der Regel sind entsprechend der Darstellung in FIG 1 Kondensatoren 9 vorhanden, über die der dritte Potenzialanschluss 8 kapazitiv mit dem ersten und dem zweiten Potenzialanschluss 4, 5 gekoppelt ist. Insbesondere dadurch wird erreicht, dass das mittlere Gleichspannungspotenzial U0 zwischen dem hohen und dem niedrigen Gleichspannungspotenzial U+, U- liegt.

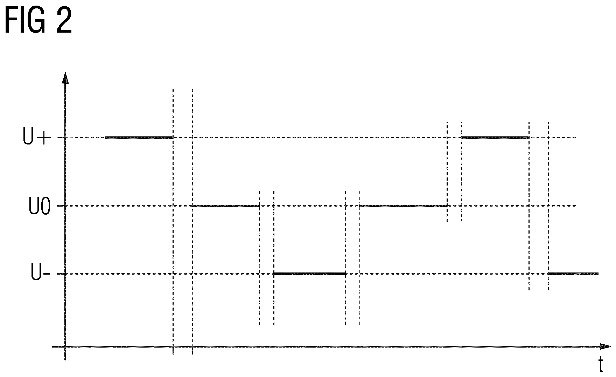

Die ersten und zweiten elektronischen Schaltelemente 2, 7 werden in aller Regel derart gesteuert, dass das Wechselspannungspotenzial U~ zu jedem Zeitpunkt auf maximal eines der Gleichspannungspotenziale U+, U-, U0 durchgeschaltet ist. Kurzzeitige Ausnahmen können jedoch ausnahmsweise während des Bestehens der transienten Zustände der ersten und zweiten elektronischen Schaltelemente 2, 7 auftreten. Das Durchschalten des Wechselspannungspotenzials U~ auf jeweils nur eines der Gleichspannungspotenziale U+, U-, U0 ist aus FIG 2 ersichtlich. FIG 2 zeigt als Funktion der Zeit t, auf welches der drei Gleichspannungspotenziale U+, U-, U0 das Wechselspannungspotenzial U~ jeweils durchgeschaltet ist. Ersichtlich sind die Schaltzeiträume, zu denen das Wechselspannungspotenzial U~ auf jeweils eines der drei Gleichspannungspotenziale U+, U-, U0 durchgeschaltet ist, durch kleine Pausen voneinander getrennt.

Zwischen dem Phasenanschluss 4 und den ersten und zweiten elektronischen Schaltelementen 2, 7 kann entsprechend der Darstellung in FIG 1 ein Widerstand R angeordnet sein. Der Widerstand R ist ein Shuntwiderstand. Er dient der Erfassung und der darauf aufbauenden Regelung des tatsächlich geschalteten Stromes. Zwischen dem Phasenanschluss 4 und den ersten und zweiten elektronischen Schaltelementen 2, 7 kann entsprechend der Darstellung in FIG 1 weiterhin eine Induktivität L angeordnet sein. Die Induktivität L dient der Stromglättung. Der Widerstand R ist, sofern er vorhanden ist, Bestandteil der elektronischen Leistungsschaltung 1. Die Induktivität L kann Bestandteil der elektronischen Leistungsschaltung 1 sein. Alternativ kann sie eine eigenständige Komponente sein, die nicht Bestandteil der elektronischen Leistungsschaltung 1 ist.

Die obenstehend in Verbindung mit den FIG 1 und 2 erläuterte elektronische Leistungsschaltung 1 ist als solche allgemein bekannt. Sie kann insbesondere bei einem Stromrichter oder bei einem Schaltnetzteil verwendet werden.

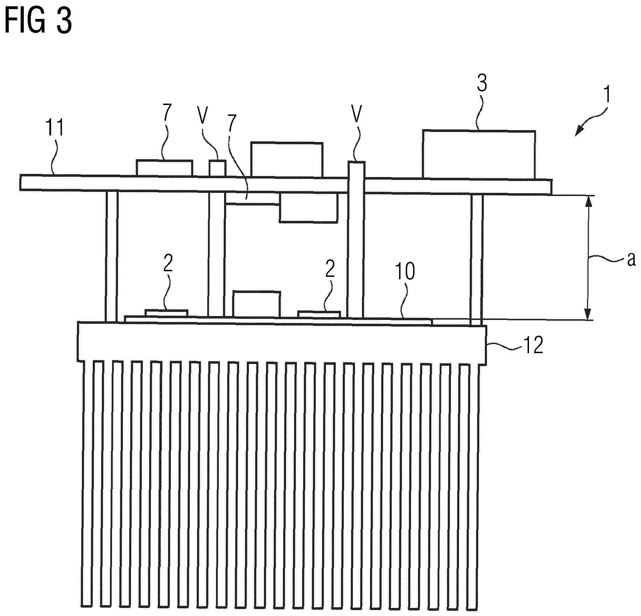

Zur Implementierung der obenstehend in Verbindung mit FIG 1 erläuterten elektronischen Leistungsschaltung 1 weist die elektronische Leistungsschaltung 1 entsprechend der Darstellung in FIG 3 ein Substrat 10 und eine erste Leiterplatte 11 auf.

Das Substrat 10 weist eine Oberseite und eine Unterseite auf. Sowohl auf der Oberseite als auch auf der Unterseite ist eine jeweilige Metallschicht aufgebracht. Die Metallschichten können strukturiert sein. Das Substrat 10 selbst besteht aus einem dielektrischen Material, das - zumindest in der Regel - eine Dicke zwischen 25 µm und 400 µm aufweist. Das dielektrische Material kann insbesondere aus einem keramischen Werkstoff bestehen, beispielsweise Aluminiumnitrid oder Aluminiumoxid. Alternativ kann es aus einem Kunststoff bestehen, beispielsweise einem Polyamid oder einem Polyimid.

Auf der Oberseite des Substrats 10 sind die ersten elektronischen Schaltelemente 2 angeordnet. Die ersten elektronischen Schaltelemente 2 können insbesondere stoffschlüssig auf dem Substrat 10 angeordnet sein. Beispiele geeigneter stoffschlüssiger Verbindungen sind eine Lötverbindung und eine Sinterverbindung. Die Verbindung der ersten elektronischen Schaltelemente 2 mit dem Substrat 10 mit wird oftmals als DCB (direct copper bonding) oder als DBC (direct bonding copper) bezeichnet. Der Widerstand R (in FIG 3 nicht dargestellt) ist, sofern er vorhanden ist, vorzugsweise ebenfalls auf der Oberseite des Substrats 10 angeordnet. Der Widerstand R kann aber auch an einer anderen Stelle angeordnet sein, beispielsweise auf der ersten Leiterplatte 11.

Die Unterseite des Substrats 10 ist mit einem Kühlkörper 12 verbunden. Der Kühlkörper 12 besteht aus einem gut wärmeleitenden Metall, typisch Aluminium oder einer Aluminiumlegierung, manchmal auch Kupfer oder einer Kupferlegierung. In aller Regel weist der Kühlkörper 12 entsprechend der Darstellung in FIG 3 Kühlrippen auf. In den ersten elektronischen Schaltelementen 2 oder anderweitig anfallende Verlustleistung kann vom Substrat 10 in den Kühlkörper 12 überführt werden und vom Kühlkörper 12 an die Umgebung abgegeben werden.

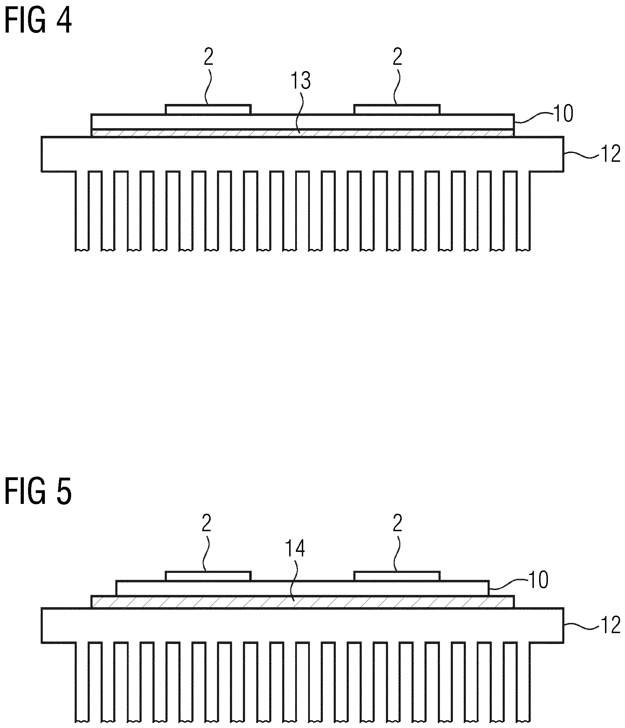

Zur guten thermischen Ankopplung des Substrats 10 an den Kühlkörper 12 ist es möglich, dass die Unterseite des Substrats 10 entsprechend der Darstellung in FIG 3 direkt mit dem Kühlkörper 12 verbunden ist. Alternativ ist es entsprechend der Darstellung in FIG 4 möglich, dass die Unterseite des Substrats 10 über eine Wärmeleitpaste 13 mit dem Kühlkörper 12 verbunden ist. Eine weitere Alternative besteht darin, dass die Unterseite des Substrats 10 entsprechend der Darstellung in FIG 5 über eine Metallschicht 14 mit dem Kühlkörper 12 verbunden ist.

Die erste Leiterplatte 11 ist in der Regel als übliche Leiterplatte ausgebildet, d.h. als Leiterplatte, die aus einem mit einem Harz getränkten Glasvlies oder einem mit Harz getränkten Glasfasergewebe besteht. Ein typisches Beispiel ist eine sogenannte FR4-Leiterplatte. Alternativ kann die Leiterplatte auch aus einem Polyimid (mit oder ohne Glasfasern) oder aus PTFE (mit oder ohne Glasfasern) bestehen. In Einzelfällen kann die Leiterplatte 11 auch aus einer Keramik bestehen, insbesondere aus Aluminiumoxid.

Die erste Leiterplatte 11 weist entsprechend der Darstellung in FIG 3 ebenfalls eine Oberseite und eine Unterseite auf. Die zweiten elektronischen Schaltelemente 7 sind zumindest auf der Oberseite der ersten Leiterplatte 11 angeordnet. Gegebenenfalls können die zweiten elektronischen Schaltelemente 7 entsprechend der Darstellung in FIG 3 teilweise auf der Oberseite und teilweise auf der Unterseite der ersten Leiterplatte 11 angeordnet sein.

Das Substrat 10 ist in einem Abstand a von der ersten Leiterplatte 11 unter der Unterseite der ersten Leiterplatte 11 angeordnet. Der Abstand a liegt üblicherweise im Bereich weniger cm. Die Oberseite des Substrats 10 ist der ersten Leiterplatte 11 zugewandt.

Das Substrat 10 ist mit der ersten Leiterplatte 11 elektrisch verbunden. Entsprechende elektrische Verbindungen V dienen zum einen der Führung der mittels der ersten elektronischen Schaltelemente 2 geschalteten Spannungen und Ströme. Die Steuereinrichtung 3 ist in der Regel auf der ersten Leiterplatte 11 angeordnet. In diesem Fall dienen die elektrischen Verbindungen V weiterhin zur Übermittlung der Steuersignale S1 und S2 an die ersten elektronischen Schaltelemente 2.

Aufgrund der Anordnung der ersten elektronischen Schaltelemente 2 auf dem Substrat 10 ist es möglich, die ersten elektronischen Schaltelemente 2 mit einer relativ hohen Verlustleistung zu betreiben. Aufgrund der Anordnung der zweiten elektronischen Schaltelemente 7 auf der ersten Leiterplatte 11 können die zweiten elektronischen Schaltelemente 7 jedoch nur mit einer geringeren Verlustleistung betrieben werden. Dies ergibt sich oftmals durch die Betriebsweise als solche ganz von selbst. Denn wenn mit A die Amplitude des Wechselspannungspotenzials U~ bezeichnet wird, kann es im ungünstigsten Fall erforderlich sein, dass die beiden ersten elektronischen Schaltelemente 2 eine Spannung schalten, die den Wert U+ zuzüglich A aufweist. Für das eine erste elektronische Schaltelemente 2 tritt dieser Fall auf, wenn das Wechselspannungspotenzial U~ aktuell gerade den Wert -A aufweist und das Wechselspannungspotenzial U~ auf das hohe Gleichspannungspotenzial U+ durchgeschaltet wird. Für das andere erste elektronische Schaltelemente 2 tritt dieser Fall auf, wenn das Wechselspannungspotenzial U~ aktuell gerade den Wert +A aufweist und das Wechselspannungspotenzial U~ auf das niedrige Gleichspannungspotenzial U- durchgeschaltet wird. Das mittlere Gleichspannungspotenzial U0 liegt hingegen in der Regel im Bereich des Nulldurchgangs des Wechselspannungspotenzials U~. Beim Durchschalten auf das mittlere Gleichspannungspotenzial U0 muss daher auch im ungünstigsten Fall im Wesentlichen lediglich eine Spannung geschaltet werden, die den Wert A aufweist.

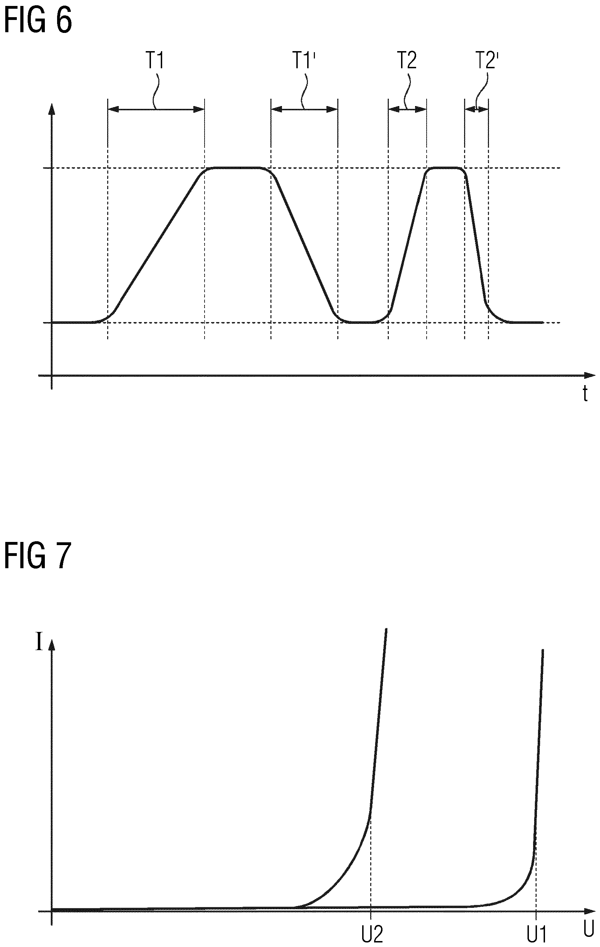

Es sind aber weitere Gründe dafür möglich, weshalb die ersten elektronischen Schaltelemente 2 im Betrieb der elektronischen Leistungsschaltung 1 eine höhere Verlustleistung aufweisen als die zweiten elektronischen Schaltelemente 7. Beispielsweise ist es entsprechend der Darstellung in FIG 6 möglich, dass die ersten elektronischen Schaltelemente 2 zum Umschalten vom gesperrten in den durchgeschalteten Zustand eine Schaltzeit T1 und zum Umschalten vom durchgeschalteten in den gesperrten Zustand eine Schaltzeit T1' benötigen, während die zweiten elektronischen Schaltelemente 7 zum Umschalten vom gesperrten in den durchgeschalteten Zustand eine Schaltzeit T2 und zum Umschalten vom durchgeschalteten in den gesperrten Zustand eine Schaltzeit T2' benötigen, wobei die Schaltzeiten T2, T2' kleiner als die Schaltzeiten T1, T1' sind. Ein Verhältnis der Schaltzeiten T1, T2 bzw. T1', T2' kann beispielsweise zwischen 3,0 und 20,0 liegen. Eine weitere mögliche Ursache für einen Unterschied in der Verlustleistung kann sein, dass entsprechend der Darstellung in FIG 7 beim Führen eines Stromes I über den ersten elektronischen Schaltelemente 2 eine Durchlassspannung U1 und über den zweiten elektronischen Schaltelemente 7 eine Durchlassspannung U2 abfällt, wobei die Durchlassspannung U2 der zweiten elektronischen Schaltelemente 7 kleiner als die Durchlassspannung U1 der ersten elektronischen Schaltelemente ist. In analoger Weise ist es auch möglich, dass die ersten elektronischen Schaltelemente 2 im durchgeschalteten Zustand einen größeren Leitendwiderstand aufweisen als die zweiten elektronischen Schaltelemente 7. Dieser letztgenannte Fall kann insbesondere bei unipolaren Schaltelementen auftreten, also insbesondere bei FETs.

Um eine besonders gute Ableitung der in den ersten elektronischen Schaltelementen 2 entstehenden Verlustleistung in das Substrat 10 und von dort weiter auf den Kühlkörper 12 zu erreichen, sind die ersten elektronischen Schaltelemente 2 vorzugsweise als gehäuselose Schaltelemente (bare die) ausgebildet. Dies ist in den FIG 3 bis 5 insbesondere dadurch angedeutet, dass die ersten elektronischen Schaltelemente 2 sehr flach gezeichnet sind. Die zweiten elektronischen Schaltelemente 7 sind hingegen in der Regel als in einem Gehäuse angeordnete Schaltelemente ausgebildet. Die zweiten elektronischen Schaltelemente 7 sind in diesem Fall - selbstverständlich - mit dem Gehäuse auf der ersten Leiterplatte 11 befestigt, beispielsweise dort aufgelötet. Die Ausbildung als in einem Gehäuse angeordnete Schaltelemente ist in FIG 3 dadurch angedeutet, dass die zweiten elektronischen Schaltelemente 7 erheblich höher und auch ein Stück breiter als die ersten elektronischen Schaltelemente 2 gezeichnet sind.

Wie bereits erwähnt, müssen die ersten elektronischen Schaltelemente 2 in der Lage sein, eine größere Spannung zu schalten und vor allem auch zu sperren als die zweiten elektronischen Schaltelemente 7. Es ist daher möglich, dass die bauartbedingten maximalen geschalteten Spannungen der ersten elektronischen Schaltelemente 2 größer als die bauartbedingten maximalen geschalteten Spannungen der zweiten elektronischen Schaltelemente sind. Dies ist in der Regel auch von Vorteil, weil ein elektronisches Schaltelement mit einer niedrigeren bauartbedingten maximalen geschalteten Spannung in der Regel kostengünstiger ist als ein im Übrigen gleichartiges elektronisches Schaltelement mit einer höheren bauartbedingten maximalen geschalteten Spannung.

Vorzugsweise weisen die maximalen geschalteten Spannungen der zweiten elektronischen Schaltelemente 7 einen Wert von 650 V oder weniger auf. Die maximalen geschalteten Spannungen der ersten elektronischen Schaltelemente 2 hingegen können auch einen größeren Wert aufweisen, beispielsweise einen Wert von 1,0 kV oder mehr. Es sind selbstverständlich aber auch andere Werte möglich. Insbesondere bei einem Wert der maximalen geschalteten Spannung der zweiten elektronischen Schaltelemente 7 von 650 V und weniger können die zweiten elektronischen Schaltelemente 7 auf Basis von Galliumnitrid ausgebildet sein und damit die Vorteile von elektronischen Schaltelementen auf Basis von Galliumnitrid genutzt werden.

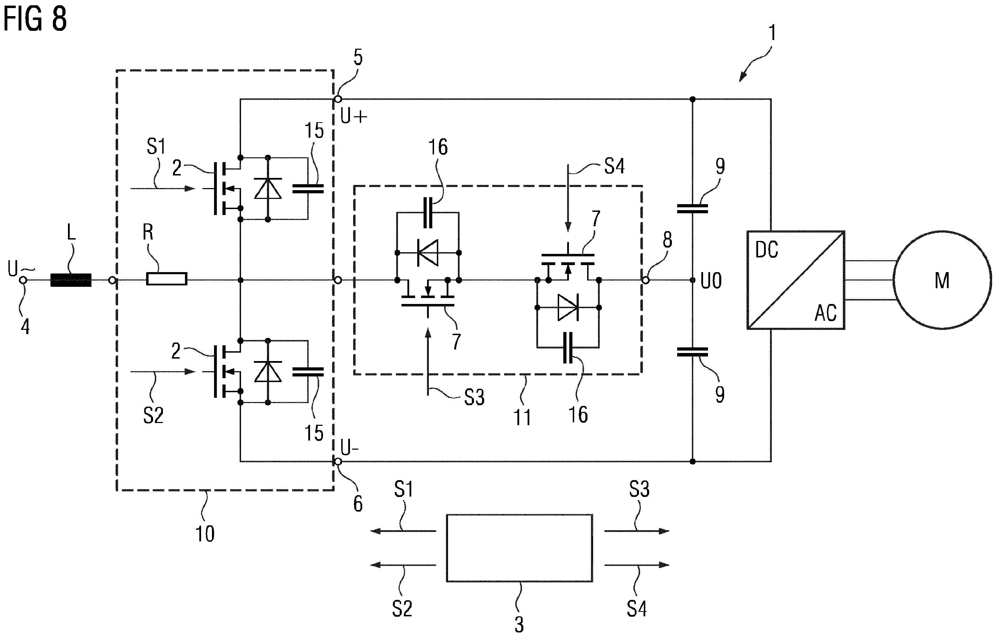

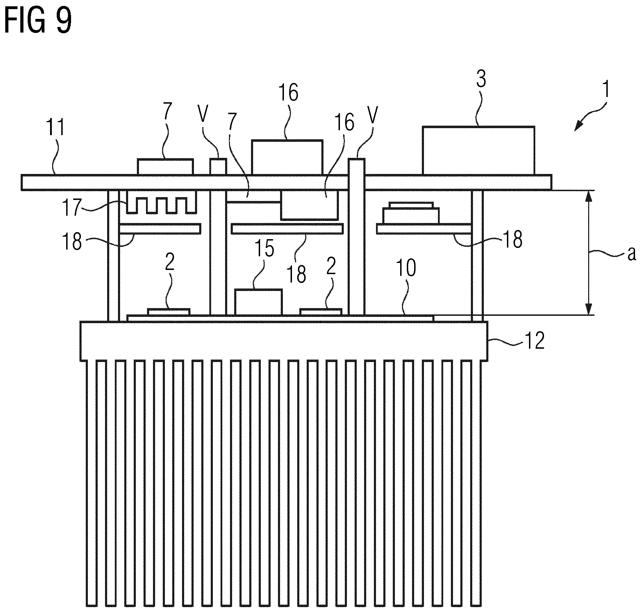

Die FIG 8 und 9 zeigen eine Modifikation der elektronischen Leistungsschaltung der FIG 1 und 3. Gemäß den FIG 8 und 9 sind erste Kondensatoren 15 vorhanden, mittels derer die ersten elektronischen Schaltelemente 2 überbrückt sind. In analoger Weise sind zweite Kondensatoren 16 vorhanden, mittels derer die zweiten elektronischen Schaltelemente 7 überbrückt sind. Aus den FIG 8 und 9 ist weiterhin ersichtlich, dass die ersten Kondensatoren 15 auf dem Substrat 10 angeordnet sind, während die zweiten Kondensatoren 16 auf der ersten Leiterplatte 11 angeordnet sind. Im Übrigen sind die obigen Ausführungen zu den FIG 1 bis 7 weiterhin gültig.

Die ersten und zweiten Kondensatoren 15, 16 sind die einfachsten Ausgestaltungen von ersten und zweiten Hilfsschaltungen, welche die ersten und zweiten elektronischen Schaltelemente 2, 7 überbrücken. Die ersten und zweiten Hilfsschaltungen könnten jedoch auch als RC-Glieder ausgebildet sein, also jeweils einen mit dem jeweiligen ersten und zweiten Kondensator 15, 16 in Reihe geschalteten Widerstand aufweisen. Durch die ersten und zweiten Hilfsschaltungen ergibt sich ein verbesserter Stromverlauf.

Gemäß den FIG 8 und 9 ist weiterhin für die beiden zweiten elektronischen Schaltelemente 7 jeweils ein eigener zweiter Kondensator 16 (bzw. allgemein jeweils eine eigene zweite Hilfsschaltung) vorhanden. Es ist jedoch alternativ möglich, die beiden zweiten elektronischen Schaltelemente 7 mittels eines einzelnen zweiten Kondensators 16 (bzw. allgemein einer einzelnen zweiten Hilfsschaltung) zu überbrücken.

FIG 9 zeigt zusätzlich zwei weitere vorteilhafte Ausgestaltungen der vorliegenden Erfindung. Diese beiden Ausgestaltungen werden nachstehend zwar gemeinsam erläutert, sind aber unabhängig voneinander realisierbar.

Zum einen sind gemäß FIG 9 auf der Unterseite der ersten Leiterplatte 11 Kühlelemente 17 angeordnet. Mittels der Kühlelemente 17 können insbesondere Verlustleistungen abgeführt werden, die in den zweiten elektronischen Schaltelementen 7 anfallen.

Zum anderen ist zwischen der ersten Leiterplatte 11 und dem Substrat 10 mindestens eine zweite Leiterplatte 18 angeordnet. Bezüglich der möglichen Ausgestaltungen der zweiten Leiterplatte 18 bzw. der zweiten Leiterplatten 18 sind die Ausführungen zur ersten Leiterplatte 11 analog anwendbar. Auf der mindestens einen zweiten Leiterplatte 18 können beispielsweise Treiber angeordnet sein. Die mindestens eine zweite Leiterplatte 18 ist mit der ersten Leiterplatte 11 und/oder dem Substrat 10 elektrisch verbunden.

Die vorliegende Erfindung wurde vorstehend in Verbindung mit einem einzelnen Phasenanschluss 4 erläutert. Es ist jedoch ebenso möglich, dass die elektronische Leistungsschaltung 1 mehrere Phasenanschlüsse 4 aufweist. In diesem Fall sind die ersten und zweiten elektronischen Schaltelemente 2, 7 für jeden Phasenanschluss 4 separat vorhanden. Die Potenzialanschlüsse 5, 6, 8 können gemeinsam genutzt werden.

Zusammengefasst betrifft die vorliegende Erfindung somit folgenden Sachverhalt:
Ein Substrat 10 und eine erste Leiterplatte 11 weisen beide jeweils eine Oberseite und eine Unterseite auf. Die Unterseite des Substrats 10 ist mit einem Kühlkörper 12 verbunden. Auf der Oberseite des Substrats 10 sind erste elektronische Schaltelemente 2 angeordnet, mittels derer ein an einem Phasenanschluss 4 anstehendes Wechselspannungspotenzial U~ auf ein an einem ersten Potenzialanschluss 5 anstehendes hohes Gleichspannungspotenzial U+ und auf ein an einem zweiten Potenzialanschluss 6 anstehendes niedriges Gleichspannungspotenzial U- durchgeschaltet werden kann. Mittels zweiter elektronischer Schaltelemente 7 kann das Wechselspannungspotenzial U~ auf ein an einem dritten Potenzialanschluss 8 anstehendes mittleres Gleichspannungspotenzial U0 durchgeschaltet werden. Das Substrat 10 ist in einem Abstand a von der ersten Leiterplatte 11 unter der Unterseite der ersten Leiterplatte 11 angeordnet, so dass die Oberseite des Substrats 10 der ersten Leiterplatte 11 zugewandt ist. Das Substrat 10 ist mit der ersten Leiterplatte 11 elektrisch verbunden. Die zweiten Schaltelemente 7 sind zumindest auf der Oberseite der ersten Leiterplatte 11 angeordnet, gegebenenfalls zusätzlich auch auf der Unterseite der ersten Leiterplatte 11.

Die vorliegende Erfindung weist viele Vorteile auf. Insbesondere ist auf flexible Weise eine kompakte elektronische Leistungsschaltung realisierbar.

## Patentansprüche

1. Elektronische Leistungsschaltung,
- wobei die elektronische Leistungsschaltung ein Substrat (10) mit einer Oberseite und einer Unterseite aufweist,
- wobei die Unterseite des Substrats (10) mit einem Kühlkörper (12) verbunden ist,
- wobei auf der Oberseite des Substrats (10) erste elektronische Schaltelemente (2) angeordnet sind, mittels derer ein an einem Phasenanschluss (4) der Leistungsschaltung anstehendes Wechselspannungspotenzial (U~) auf ein an einem ersten Potenzialanschluss (5) der Leistungsschaltung anstehendes hohes Gleichspannungspotenzial (U+) und auf ein an einem zweiten Potenzialanschluss (6) der Leistungsschaltung anstehendes niedriges Gleichspannungspotenzial (U-) durchgeschaltet werden kann,
- wobei die elektronische Leistungsschaltung zweite elektronische Schaltelemente (7) aufweist, mittels derer das an dem Phasenanschluss (4) anstehende Wechselspannungspotenzial (U~) auf ein an einem dritten Potenzialanschluss (8) der Leistungsschaltung anstehendes mittleres Gleichspannungspotenzial (U0) durchgeschaltet werden kann,
- wobei die elektronische Leistungsschaltung zusätzlich zu dem Substrat (10) eine erste Leiterplatte (11) mit einer Oberseite und einer Unterseite aufweist,
- wobei das Substrat (10) in einem Abstand (a) von der ersten Leiterplatte (11) unter der Unterseite der ersten Leiterplatte (11) angeordnet ist, so dass die Oberseite des Substrats (10) der ersten Leiterplatte (11) zugewandt ist,
- wobei das Substrat (10) mit der ersten Leiterplatte (11) elektrisch verbunden ist,
**dadurch gekennzeichnet,**
- **dass** die zweiten elektronischen Schaltelemente (7) zumindest auf der Oberseite der ersten Leiterplatte (11), gegebenenfalls zusätzlich auch auf der Unterseite der ersten Leiterplatte (11), angeordnet sind.

2. Leistungsschaltung nach Anspruch 1,
**dadurch gekennzeichnet,**
**dass** die ersten elektronischen Schaltelemente (2) im Betrieb der elektronischen Leistungsschaltung eine höhere Verlustleistung aufweisen als die zweiten elektronischen Schaltelemente (7).

3. Leistungsschaltung nach Anspruch 1 oder 2,
**dadurch gekennzeichnet,**
**dass** die ersten elektronischen Schaltelemente (2) eine höhere Durchlassspannung (U1) und/oder größere Schaltzeiten (T1, T1') und/oder einen größeren Leitendwiderstand als die zweiten elektronischen Schaltelemente (7) aufweisen.

4. Leistungsschaltung nach Anspruch 1, 2 oder 3,
**dadurch gekennzeichnet,**
**dass** die ersten elektronischen Schaltelemente (2) und die zweiten elektronischen Schaltelemente (7) in unterschiedlichen Halbleitertechnologien realisiert sind, insbesondere die ersten elektronischen Schaltelemente (2) als Schaltelemente auf Siliziumcarbid-Basis ausgebildet sind und die zweiten elektronischen Schaltelemente (7) als Schaltelemente auf Galliumnitrid-Basis ausgebildet sind.

5. Leistungsschaltung nach einem der obigen Ansprüche,
**dadurch gekennzeichnet,**
**dass** die ersten elektronischen Schaltelemente (2) als gehäuselose Schaltelemente ausgebildet sind.

6. Leistungsschaltung nach einem der obigen Ansprüche,
**dadurch gekennzeichnet,**
**dass** die zweiten elektronischen Schaltelemente (7) als in einem Gehäuse angeordnete Schaltelemente ausgebildet sind und dass die zweiten elektronischen Schaltelemente (7) mit dem Gehäuse auf der ersten Leiterplatte (11) befestigt sind.

7. Leistungsschaltung nach einem der obigen Ansprüche,
**dadurch gekennzeichnet,**
**dass** bauartbedingte maximale geschaltete Spannungen der ersten elektronischen Schaltelemente (2) größer als bauartbedingte maximale geschaltete Spannungen der zweiten elektronischen Schaltelemente (7) sind.

8. Leistungsschaltung nach einem der obigen Ansprüche,
**dadurch gekennzeichnet,**
**dass** die ersten elektronischen Schaltelemente (2) mittels erste Kondensatoren (15) enthaltender erster Hilfsschaltungen überbrückt sind und dass die ersten Hilfsschaltungen auf dem Substrat (10) angeordnet sind.

9. Leistungsschaltung nach einem der obigen Ansprüche,
**dadurch gekennzeichnet,**
**dass** die zweiten elektronischen Schaltelemente (2) mittels zweite Kondensatoren (16) enthaltender zweiter Hilfsschaltungen überbrückt sind und dass die zweiten Hilfsschaltungen auf der ersten Leiterplatte (11) angeordnet sind.

10. Leistungsschaltung nach einem der obigen Ansprüche,
**dadurch gekennzeichnet,**
**dass** auf der Unterseite der ersten Leiterplatte (11) Kühlelemente (17) angeordnet sind, mittels derer in den zweiten elektronischen Schaltelementen (7) anfallende Verlustleistungen abgeführt werden.

11. Leistungsschaltung nach einem der obigen Ansprüche,
**dadurch gekennzeichnet,**
**dass** zwischen der ersten Leiterplatte (11) und dem Substrat (10) mindestens eine mit der ersten Leiterplatte (11) und/ oder dem Substrat (10) elektrisch verbundene zweite Leiterplatte (18) angeordnet ist.

12. Leistungsschaltung nach einem der obigen Ansprüche,
**dadurch gekennzeichnet,**
**dass** die Unterseite des Substrats (10) mit dem Kühlkörper (12) direkt, über eine Wärmeleitpaste (13) oder über eine Metallschicht (14) verbunden ist.

13. Leistungsschaltung nach einem der obigen Ansprüche,
**dadurch gekennzeichnet,**
**dass** sie bei einem Stromrichter oder bei einem Schaltnetzteil verwendet wird.

## Claims

1. Electronic power circuit,
- wherein the electronic power circuit has a substrate (10) with an upper side and a lower side,
- wherein the lower side of the substrate (10) is connected to a cooling body (12),
- wherein arranged on the upper side of the substrate (10) are first electronic switching elements (2), by means of which an alternating current potential (U~) present at a phase terminal (4) of the power circuit can be connected through to a high direct current potential (U+) present at a first potential terminal (5) of the power circuit and to a low direct current potential (U-) present at a second potential terminal (6) of the power circuit,
- wherein the electronic power circuit has second electronic switching elements (7), by means of which the alternating current potential (U~) present at the phase terminal (4) can be connected through to a middle direct current potential (U0) present at a third potential terminal (8) of the power circuit,
- wherein, in addition to the substrate (10), the electronic power circuit has a first circuit board (11) with an upper side and a lower side,
- wherein the substrate (10) is arranged at a spacing (a) from the first circuit board (11) under the lower side of the first circuit board (11), so that the upper side of the substrate (10) faces toward the first circuit board (11),
- wherein the substrate (10) is electrically connected to the first circuit board (11),
**characterised in that**
- the second electronic switching elements (7) are arranged at least on the upper side of the first circuit board (11), possibly additionally also on the lower side of the first circuit board (11).

2. Power circuit according to claim 1,
**characterised in that**
during operation of the electronic power circuit, the first electronic switching elements (2) have a higher power loss than the second electronic switching elements (7).

3. Power circuit according to claim 1 or 2,
**c h a r act e r i sed in** that
the first electronic switching elements (2) have a higher conducting state voltage (U1) and/or greater switching times (T1, T1') and/or a greater conductive resistance than the second electronic switching elements (7).

4. Power circuit according to claim 1, 2 or 3,
**characterised in that**
the first electronic switching elements (2) and the second electric switching elements (7) are realized in different semiconductor technologies, in particular, the first electronic switching elements (2) are configured as switching elements on the basis of silicon carbide and the second electronic switching elements (7) are configured as switching elements on the basis of gallium nitride.

5. Power circuit according to one of the above claims,
**characterised in that**
the first electronic switching elements (2) are configured as housing-free switching elements.

6. Power circuit according to one of the above claims,
**characterised in that**
the second electronic switching elements (7) are configured as switching elements arranged in a housing and **in that** the second electronic switching elements (7) are fastened with the housing on the first circuit board (11).

7. Power circuit according to one of the above claims,
**characterised in that**
the design-limited maximum switched voltages of the first electronic switching elements (2) are higher than the design-limited maximum switched voltages of the second electronic switching elements (7).

8. Power circuit according to one of the above claims,
**characterised in that**
the first electronic switching elements (2) are bridged by means of first auxiliary circuits containing first capacitors (15) and **in that** the first auxiliary circuits are arranged on the substrate (10).

9. Power circuit according to one of the above claims,
**characterised in that**
the second electronic switching elements (2) are bridged by means of second auxiliary circuits containing second capacitors (16) and **in that** the second auxiliary circuits are arranged on the first circuit board (11).

10. Power circuit according to one of the above claims,
**characterised in that**
arranged on the lower side of the first circuit board (11) are cooling elements (17) by means of which power losses arising in the second electronic switching elements (7) are conducted away.

11. Power circuit according to one of the above claims,
**characterised in that**
at least one second circuit board (18) which is electrically connected to the first circuit board (11) and/or the substrate (10) is arranged between the first circuit board (11) and the substrate (10).

12. Power circuit according to one of the above claims,
**characterised in that**
the lower side of the substrate (10) is connected to the cooling body (12) directly, via a heat-conducting paste (13) or via a metal layer (14).

13. Power circuit according to one of the above claims,
**characterised in that**
it is used for a power converter or for a switched mode power supply.

## Revendications

1. Circuit de puissance électronique,
- dans lequel le circuit de puissance électronique comporte un substrat (10) ayant une face supérieure et une face inférieure,
- dans lequel la face inférieure du substrat (10) est reliée à un puits (12) de chaleur,
- dans lequel, sur la face supérieure du substrat (10), sont disposés un premier élément (2) électronique de coupure, au moyen duquel un potentiel (U~) de tension alternative s'appliquant à une borne (4) de phase du circuit de puissance peut être connecté à un haut potentiel (U+) de tension continue s'appliquant à une première borne (5) de potentiel du circuit de puissance et à un bas potentiel (U-) de tension continue s'appliquant à une deuxième borne (6) de potentiel du circuit de puissance,
- dans lequel le circuit de puissance électronique comporte deux éléments (7) de coupure électroniques, au moyen desquels le potentiel (U~) de tension alternative s'appliquant à la borne (4) de phase peut être connecté à un moyen potentiel (U0) de tension continue s'appliquant à une troisième borne (8) de potentiel du circuit de puissance,
- dans lequel le circuit de puissance électronique comporte, en plus du substrat (10), une première plaquette (11) à circuit imprimé ayant une face supérieure et une face inférieure,
- dans lequel le substrat (10) est disposé à une distance (a) de la première plaquette (11) à circuit imprimé sous la face inférieure de la première plaquette (11) à circuit imprimé, de manière à ce que la face supérieure du substrat (10) soit tournée vers la première plaquette (11) à circuit imprimé,
- dans lequel le substrat (10) est connecté électriquement à la première plaquette (11) à circuit imprimé,
**caractérisé**
- **en ce que** les deuxièmes éléments (7) électroniques de coupure sont disposés au moins sur la face supérieure de la première plaquette (11) à circuit imprimé, le cas échéant en outre également sur la face inférieure de la première plaquette (11) à circuit imprimé.

2. Circuit de puissance suivant la revendication 1, **caractérisé**
**en ce que** les premiers éléments (2) électroniques de coupure ont, lorsque le circuit de puissance électronique est en fonctionnement, une dissipation de puissance plus grande que les deuxièmes éléments (7) électroniques de coupure.

3. Circuit de puissance suivant la revendication 1 ou 2, **caractérisé**
**en ce que** les premiers éléments (2) électroniques de coupure ont une tension (U1) directe plus haute et/ou des temps (T1, T1') de coupure plus grands et/ou une résistance à la conduction plus grande que les deuxièmes éléments (7) électroniques de coupure.

4. Circuit de puissance suivant la revendication 1, 2 ou 3, **caractérisé**
**en ce que** les premiers éléments (2) électroniques de coupure et les deuxièmes éléments (7) électroniques de coupure sont réalisés suivant des technologies de semiconducteur différentes, en particulier les premiers éléments (2) électroniques sont constitués sous la forme d'éléments de coupure à base de carbure de silicium et les deuxièmes éléments (7) électroniques de coupure sont constitués sous la forme d'éléments de coupure à base de nitrure de galium.

5. Circuit de puissance suivant l'une des revendications précédentes,
**caractérisé**
**en ce que** les premiers éléments (2) électroniques de coupure sont constitués sous la forme d'éléments de coupure sans boîtier.

6. Circuit de puissance suivant l'une des revendications précédentes,
**caractérisé**
**en ce que** les deuxièmes éléments (7) électroniques de coupure sont constitués sous la forme d'éléments de coupure disposés dans un boîtier et en ce que les deuxièmes éléments (7) électroniques de coupure sont fixés par le boîtier sur la première plaquette (11) à circuit imprimé.

7. Circuit de puissance suivant l'une des revendications précédentes,
**caractérisé**
**en ce que** des tensions appliquées au maximum dues au type de construction des premiers éléments (2) électroniques de coupure sont plus hautes que des tensions appliquées au maximum dues au type de construction des deuxièmes éléments (7) électroniques de coupure.

8. Circuit de puissance suivant l'une des revendications précédentes,
**caractérisé**
**en ce que** les premiers éléments (2) électroniques de coupure sont court-circuités au moyen de premiers circuits auxiliaires contenant des premiers condensateurs (15) et en ce que les premiers circuits auxiliaires sont disposés sur le substrat (10).

9. Circuit de puissance suivant l'une des revendications précédentes,
**caractérisé**
**en ce que** les deuxièmes éléments (2) électroniques de coupure sont court-circuités au moyen de deuxièmes circuits auxiliaires contenant des deuxièmes condensateurs (16) et en ce que les deuxièmes circuits auxiliaires sont disposés sur la première plaquette (11) à circuit imprimé.

10. Circuit de puissance suivant l'une des revendications précédentes,
**caractérisé**
**en ce que** sur la face inférieure de la première plaquette (11) à circuit imprimé sont disposés des éléments (17) de refroidissement, au moyen desquels des puissances perdues se produisant dans les deuxièmes éléments (7) électroniques de coupure sont dissipées.

11. Circuit de puissance suivant l'une des revendications précédentes,
**caractérisé**
**en ce qu'**une deuxième plaquette (18) à circuit imprimé, reliée électriquement à la première plaquette (11) à circuit imprimé et/ou au substrat (10), est disposée entre la première plaquette (11) à circuit imprimé et le substrat (10).

12. Circuit de puissance suivant l'une des revendications précédentes,
**caractérisé**
**en ce que** la face inférieure du substrat (10) est reliée directement au puits (12) de chaleur par l'intermédiaire d'une pâte (13) conductrice de la chaleur ou par l'intermédiaire d'une couche (14) métallique.

13. Circuit de puissance suivant l'une des revendications précédentes,
**caractérisé**
**en ce qu'**il est utilisé dans une alimentation à découpage.
